# FASCICULE DE BREVET EUROPEEN

(11) **EP 1 754 888 B1**
(45) Date de publication et mention de la délivrance du brevet: **08.04.2009**
(21) Numéro de dépôt: 06116150.1
(22) Date de dépôt: 27.06.2006
(51) Int. Cl.: F04B 37/14, F04B 37/08, F04B 51/00

(54) **Ligne de vide et procédé de surveillance d'une telle ligne**
Vakuum-Pumpeinrichtung und Verfahren zur Lebensdauerüberwachung der Einrichtung
Vacuum pumping system and method of diagnosing life expectancy of said system

(30) Priorité: 04.07.2005 FR 0552027
(43) Date de publication de la demande: 21.02.2007
(73) Titulaire: Alcatel Lucent, 75008 Paris (FR)
(72) Inventeur: Becourt, Nicolas, 74330, POISY (FR)
(74) Mandataire: Sciaux, Edmond

(56) Documents cités:
- EP-A- 0 918 159
- US-A1- 2003 154 052
- US-A1- 2003 158 705
- US-A1- 2004 143 418

## Description

La présente invention se rapporte au domaine de la maintenance prédictive et préventive d'une ligne de vide associée à une chambre de procédé. Elle concerne plus particulièrement le suivi de la progression du phénomène de pollution par des produits solides dans la ligne de vide (bouchage, grippage, etc ...). L'invention s'étend en outre au procédé de surveillance de ce phénomène afin d'établir un diagnostic et de pouvoir programmer les interventions de maintenance préventive.

Des lignes de vide incluant au moins un groupe de pompage sont employées dans de nombreux procédés utilisant des gaz et nécessitant une pression inférieure à la pression atmosphérique. Or les gaz mis en oeuvre dans ces procédés peuvent se transformer en sous-produits solides. Ces sous-produits peuvent se déposer sous la forme d'une couche sur les surfaces internes de la ligne de vide, et notamment sur la surface des canalisations, vannes et autres accessoires, ainsi que sur les pièces mobiles et statiques de la pompe, ou encore s'accumuler dans des volumes morts de la ligne de vide. Ce phénomène peut conduire à une perte de performance de la ligne de vide, et notamment du groupe de pompage, voire à sa défaillance. Il est alors inévitable d'interrompre le déroulement du procédé dans la chambre associée pour procéder au nettoyage ou au remplacement de l'élément concerné de la ligne de vide et notamment du groupe de pompage. Les coûts induits par ces interruptions non programmées de la production sont considérables.

Aujourd'hui la maintenance d'une ligne de vide est basée à la fois sur des actions correctives et préventives.

Des maintenances correctives sont réalisées en fonction de signaux notamment émis par des capteurs intégrés au groupe de pompage. Deux seuils ont été définis pour chaque mesure analogique : un seuil d'alerte et un seuil d'alarme. Le seuil d'alerte correspond à une valeur analogique anormalement élevée, synonyme d'une dérive des conditions d'utilisation du groupe de pompage par rapport à ses capacités nominales. Le franchissement du seuil d'alarme signifie que les conditions d'utilisation du groupe de pompage ont dépassé les capacités nominales, et celui-ci s'arrête automatiquement. Afin de minimiser l'importance de l'intervention, la meilleure situation serait de pouvoir effectuer une action corrective dès le niveau d'alerte dépassé.

Des opérations de maintenance préventive partielle ou totale sont également effectuées selon une périodicité définie en fonction de l'application pour laquelle est utilisée la ligne de vide. Cette périodicité est d'abord évaluée théoriquement puis ajustées par l'expérience. Cependant la périodicité n'est pas toujours bien adaptée à l'état d'usure réelle des composants du groupe de pompage ou à l'état de pollution réel de la ligne de vide, ce qui peut engendrer des opérations trop tardives ou bien trop précoces.

Dans le cas de la maintenance corrective, la difficulté réside dans le suivi des seuils d'alerte et d'alarme des signaux analogiques du groupe de pompage qui ne permet pas un diagnostic élaboré de la cause de la défaillance. Un autre problème est la progression temporelle du comportement anormal du groupe de pompage pouvant provoquer un passage rapide du seuil d'alerte au seuil d'alarme. Dans ce cas il devient presque impossible d'intervenir avant le seuil d'alarme, ce qui peut entraîner des dommages irrémédiables au niveau du produit en cours de fabrication (par exemple une plaquette de semiconducteur), mais également au niveau du groupe de pompage.

Le document EP-0 828 332 concerne l'évaluation de la durée d'utilisation d'une pompe à vide entre les opérations de maintenance. L'estimation du dépôt de matériau indésirable sur le rotor de la pompe à vide se fait par la mesure du couple de rotation et/ou du courant du moteur entraînant le rotor.

Le procédé décrit dans ce document présente l'inconvénient de ne s'intéresser qu'à des paramètres relatifs au moteur. D'une part cette mesure est polluée par les variations de flux du gaz pompé, lequel flux n'est pas connu. Il n'est donc pas possible, au moment de la mesure, de distinguer si la variation de couple ou de courant est due à une variation de flux ou une pollution de la pompe. L'utilisation de ce procédé est donc limitée aux faibles flux, de telle sorte que l'influence du flux sur le couple moteur soit négligeable par rapport à une pollution de la pompe. D'autre part ce procédé n'évalue que le comportement dynamique des pièces de rotation de la pompe. Il ne permet pas de diagnostiquer la cause de comportements anormaux si elle est liée au mauvais fonctionnement d'éléments extérieurs au groupe de pompage, tel que le bouchage du système d'évacuation des gaz.

Le document US-2004/143,418 s'intéresse à la détermination du délai dans lequel survient une défaillance sur une pompe sèche. L'estimation de la durée de vie d'une telle pompe s'effectue par exploitation statistique des données caractéristiques de la pompe (courant, température, vibrations, etc ...) combinées aux caractéristiques du procédé de fabrication (flux de gaz, pression, température du substrat, etc ...). En effet ce document précise qu'il est extrêmement difficile de prédire la durée de vie de la pompe sans tenir compte des conditions opératoires du procédé.

Dans ce cas le nombre de paramètres à surveiller est important, ce qui rend leur exploitation complexe. De plus, le système d'analyse prédictive n'est pas autonome : il dépend d'informations fournies par l'équipement de production nécessitant l'installation d'une ligne de communication entre l'équipement et le serveur de supervision des pompes. Cette ligne de communication est difficile à établir (confidentialité des données de l'équipementier ou du client, difficultés techniques, etc ...) et son bon fonctionnement n'est pas garanti.

Le document WO 2004/011810 concerne un procédé de surveillance de l'état d'un système incluant une pompe, à la suite d'une phase de test de la pompe dans des conditions pré-établies. Pendant la période de test, on enregistre des signaux représentatifs du bon fonctionnement du système. Le diagnostic de la pompe est effectué par la mesure du couple ou du courant consommé par le moteur lors de la phase de test, c'est à dire en dehors des phases de production. Les conditions du test, et notamment le flux gazeux pompé, sont pré-établies afin de comparer le résultat de la mesure à une référence enregistrée dans les mêmes conditions de flux gazeux.

Cette méthode n'est pas possible à mettre en oeuvre lors des périodes de production soutenue car pour des raisons d'organisation, il est très difficile d'interrompre la production afin de procéder au test du groupe de pompage. De plus, ce procédé ne permet pas la prédiction du bouchage du système d'évacuation de la pompe.

Le problème est donc de diagnostiquer l'état de pollution solide (bouchage, grippage, etc ...) d'une ligne de vide, comprenant au moins un groupe de pompage, afin de planifier les opérations de maintenance préventive au moment le plus opportun et d'anticiper une défaillance du groupe de pompage, sur n'importe quelle valeur de flux pompé, sans considérer les conditions et paramètres autres que ceux provenant de la ligne de vide et sons interrompre la production.

L'objet de la présent invention est une ligne de vide pour le pompage des gaz dans une chambre de procédé, comportant au moins
- un groupe de pompage comprenant un corps de pompe et un moteur,
- un système d'évacuation des gaz pompés hors du corps de pompe,
- uns premier moyen de mesure d'un paramètre fonctionnel relatif au moteur, et
- un moyen de prévisions de la durée d'utilisation de la ligne de vide.

Selon l'invention, le moyen de prévision calcule la durée d'utilisation de la ligne de vide avant défaillance du groupe de pompage, à partir de signaux internes à la ligne de vide, lesdits, signaux étant la mesure d'un paramètre fonctionnel relatif au moteur fournie par le premier moyen et la mesure d'un paramètre fonctionnel relatif au système d'évacuation fourni par un deuxième moyen de mesure d'un paramètre fonctionnel relatif au système d'évacuation des gaz pompés hors du corps de pompe.

Le moyen de mesure d'un paramètre fonctionnel relatif au moteur est un moyen de mesure d'au moins une caractéristique choisie de préférence parmi la puissance ou le courant consommé par le moteur, le couple de rotation et les vibrations. De préférence encore le moyen de mesure d'un paramètre fonctionnel relatif au moteur est un moyen de mesure de la puissance consommée par le moteur.

Le moyen de mesure d'un paramètre fonctionnel relatif au système d'évacuation est un moyen de mesure de la pression des gaz dans le système d'évacuation.

La ligne de vide selon l'invention comprend de préférence un premier moyen de mesure de la puissance consommée par le moteur, un deuxième moyen de mesure de la pression des gaz dans le système d'évacuation, et un moyen de prévision de la durée d'utilisation de la ligne de vide à partir de la mesure de la puissance consommée par le moteur et de la mesure de la pression des gaz dans le système d'évacuation.

Selon une variante de l'invention, la ligne de vide peut comporter en outre un troisième moyen de mesure d'un paramètre fonctionnel relatif au corps de pompe. Le moyen de mesure d'un paramètre fonctionnel relatif au corps de pompe est un moyen de mesure d'au moins une caractéristique choisie de préférence parmi la température du corps de pompe, les vibrations mécaniques et/ou acoustiques du corps de pompe, le débit de purge d'azote et la position des vannes de régulation thermique.

De préférence la ligne de vide comporte en outre un moyen de prévision de la durée d'utilisation de la ligne de vide utilisant la mesure d'un paramètre fonctionnel relatif au corps de pompe.

A cette fin d'autres capteurs peuvent aussi être intégrés au groupe de pompage, comme par exemple un capteur vibratoire, un capteur acoustique ou un accéléromètre.

Avantageusement le moyen de prévision calcule la durée d'utilisation de la ligne de vide avant défaillance du groupe de pompage, à partir de la mesure d'un paramètre fonctionnel relatif au moteur fournie par le premier moyen, de la mesure d'un paramètre fonctionnel relatif au système d'évacuation fourni par le deuxième moyen et de la mesure d'un paramètre fonctionnel relatif au corps de pompe fournie par le troisième moyen.

La ligne de vide selon l'invention est ainsi capable de réaliser un auto-diagnostic, c'est à dire un diagnostic effectué sans corrélation avec des signaux extérieurs à la ligne de vide.

L'utilisation d'une ligne de vide selon l'invention comprenant un système apte à fournir un diagnostic permet, en les prévoyant, d'éviter les défaillances majeures lorsque l'installation dont fait partie la ligne de vide est dans une phase de production active. Toute défaillance dans ces circonstances peut nuire à la qualité du produit en cours de fabrication voir entraîner sa destruction ce qui génère une perte financière importante pour le client.

L'invention a aussi pour objet un procédé de surveillance d'une ligne de vide telle que décrite ci-dessus, comprenant les étapes suivantes :
- on mesure un paramètre fonctionnel relatif au moteur,
- on mesure un paramètre fonctionnel relatif au système d'évacuation des gaz,
- on effectue la corrélation de l'évolution temporelle du paramètre fonctionnel relatif au moteur et du paramètre fonctionnel relatif au système d'évacuation,
- on en déduit la durée d'utilisation de la ligne de vide prévisible avant défaillance.
   Le procédé selon l'invention consiste à identifier et suivre la progression du phénomène de pollution dans une ligne de vide. La pollution est due aux sous-produits solides issus de la transformation des gaz du procédé mis en oeuvre dans une chambre de procédé à laquelle est associée la ligne de vide. La surveillance de ce phénomène est réalisée par l'exploitation de l'évolution temporelle caractéristique de certains signaux issus des moyens de mesure, tels que des capteurs disposés sur le système d'évacuation et sur le moteur d'entraînement de la pompe.
   La prévision de la durée d'utilisation est obtenue notamment par un traitement statistique basé sur l'évolution temporelle de l'amplitude des paramètres mesurés dans le but d'évaluer le risque de colmatage de la ligne de vide.
   Les paramètres qui sont suivis de préférence dans le cadre de l'invention sont d'une part au moins un paramètre fonctionnel relatif au moteur, et d'autre part au moins un paramètre fonctionnel relatif au système d'évacuation.
   Le paramètre fonctionnel mesuré relatif au moteur est au moins une caractéristique choisie de préférence parmi la puissance ou le courant consommé par le moteur, le couple de rotation et les vibrations. De préférence encore le paramètre fonctionnel mesuré relatif au moteur est la puissance consommée.
   Le paramètre fonctionnel mesuré relatif au système d'évacuation est de préférence la pression des gaz dans le système d'évacuation.
   Les paramètres dont le suivi en corrélation est particulièrement avantageux sont la puissance consommée par le moteur et la pression des gaz dans le système d'évacuation. Selon un mode de réalisation avantageux de l'invention, le paramètre fonctionnel mesuré relatif au moteur est la puissance consommée par le moteur, le paramètre fonctionnel mesuré relatif au système d'évacuation des gaz est la pression des gaz dans le système d'évacuation, et la durée d'utilisation de la ligne de vide est calculée à partir l'évolution temporelle corrélée de la puissance consommée par le moteur et de la pression des gaz dans le système d'évacuation.
   On peut mesurer en outre un paramètre fonctionnel relatif au corps de pompe. Le paramètre fonctionnel relatif au corps de pompe est au moins une caractéristique choisie de préférence parmi la température du corps de pompe, les vibrations du corps de pompe, le débit de purge d'azote, la position des vannes de régulation thermique. L'information sur l'état ouvert ou fermé des vannes d'eau de régulation thermique peut révéler par exemple une défaillance du réseau de refroidissement non visible directement par la lecture de la température du corps de pompe.
   Il est aussi possible de compléter le diagnostic de l'état de fonctionnement des pompes et l'organisation de la maintenance par l'observation directe de l'évolution des paramètres du groupe de pompage dans le temps grâce à l'enregistrement des données par le réseau de supervision auquel les pompes sont connectées.
   Le suivi et la corrélation de l'évolution temporelle de chacun des paramètres choisis peuvent en outre comprendre facultativement la corrélation des paramètres mesurés avec des paramètres extérieurs à la ligne de vide, comme par exemple des paramètres caractéristiques de l'équipement auquel la ligne de vide est connectée.
   L'invention présente de nombreux avantages. Le procédé selon l'invention utilise et exploite les données fournit par les moyens de mesure associés à la ligne de vide, qui peuvent être enregistrées, afin d'identifier le comportement anormal du groupe de pompage et de réaliser un diagnostic dans le but d'anticiper précocement un problème avant le dépassement des seuils d'alerte et d'alarme des signaux analogiques.
   Le procédé selon l'invention permet d'identifier l'influence de la pollution sur l'état de propreté du système d'évacuation des gaz. Le procédé selon l'invention détecte ainsi la pollution d'éléments externes au groupe de pompage comme la canalisation d'évacuation des gaz pompés, un piège ou une vanne en ligne sur cette canalisation, ou encore le raccordement de cette canalisation au système de traitement des gaz
   Utilisé dans un système de diagnostic, le procédé selon l'invention permet de privilégier la maintenance prédictive, c'est à dire maintenir la ligne de vide uniquement lorsqu'il y a un besoin réel. Ceci permet d'éviter des opérations de maintenance préventive coûteuses et parfois injustifiées. Le diagnostic est précoce, ce qui permet de minimiser les dommages liés à l'usure des composants et donc de diminuer encore le coût de la maintenance.
   La présente invention est utilisable dans une application logicielle de diagnostic qui peut être intégrée au réseau de supervision du groupe de pompage in situ, au groupe de pompage lui-même, ou encore à un système à distance. L'invention peut permettre à cette application logicielle de réaliser un auto-diagnostic de la ligne de vide, c'est à dire sans corrélation avec des signaux extérieurs au groupe de pompage.
   Associée à un système de veille diagnostique automatique, l'invention permet d'alléger la surveillance routinière de la ligne de vide et ainsi d'augmenter la disponibilité des personnels en charge de leur maintenance.
   D'autres objets, caractéristiques et avantages de la présente invention ressortiront de la description suivante d'un mode de réalisation particulier, donné à titre illustratif, mais nullement limitatif, et dans le dessin annexé sur lequel
- la figure 1 représente de façon schématique une ligne de vide selon l'invention,
- la figure 2 montre la variation répétitive de la puissance consommée par le moteur et de la pression des gaz dans le système d'évacuation qui est liée aux variations du flux gazeux admis dans le groupe de pompage au cours du traitement ; la puissance consommée par le moteur M en watts (W) et la pression des gaz G en millibars (mbar) sont données en ordonnée, et en abscisse le temps T sans unités ;
- la figure 3 montre une variation ponctuelle de la puissance consommée par le moteur et de la pression des gaz qui est causée par le pompage de gaz depuis la pression atmosphérique ; la puissance M en watts est donnée en ordonnée gauche et la pression G en millibars en ordonnée droite, et en abscisse le temps T sans unités ;
- la figure 4 montre la diminution progressive de la puissance consommée par le moteur après le démarrage ; la puissance M en watts et la pression G en millibars sont données en ordonnée, et en abscisse le temps T sans unités ;
- la figure 5 montre une augmentation progressive de la puissance consommée par le moteur et de la pression des gaz qui est causée par le colmatage de la canalisation d'évacuation, la puissance M en watts et la pression G en millibars sont données en ordonnée, et en abscisse le temps T sans unités,
- la figure 6 montre la variation aléatoire de la puissance consommée par le moteur présageant un blocage imminent des pièces dynamique du groupe de pompage, la puissance M en watts est donnée en ordonnée, et en abscisse le temps T sans unités,

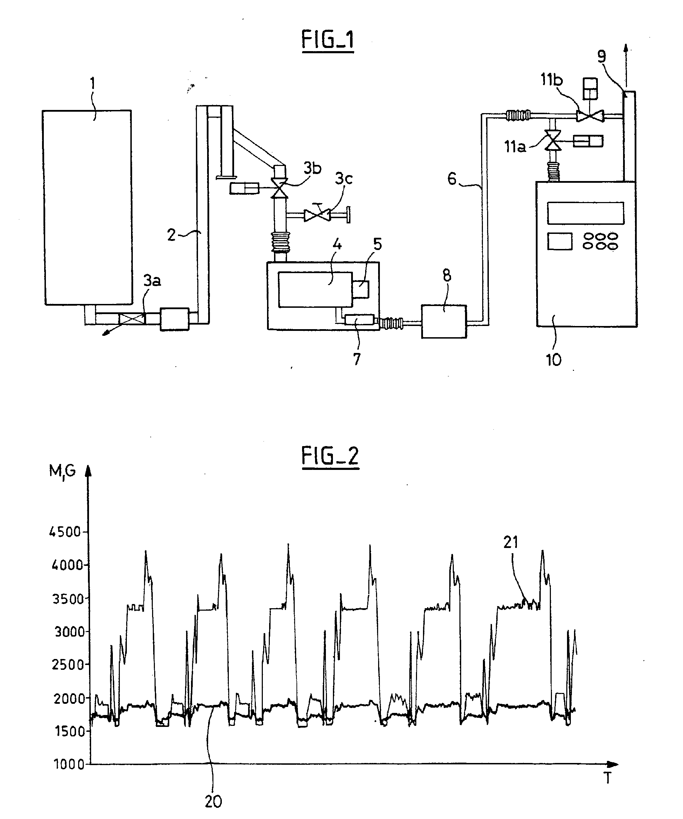

L'installation représentée sur la figure 1 comporte une chambre de procédé 1 destinée au traitement d'un substrat. Il peut s'agir par exemple de procédés de dépôts, gravure, implantation ionique ou traitement thermique utilisés dans la fabrication de dispositifs microélectronique sur des plaquettes de silicium. Il peut également s'agir de micro-usinage de substrats semi-conducteurs pour la réalisation de composants de microsystèmes électromécaniques (MEMS) ou de microsystèmes électro-optomécaniques (MOEMS). La chambre de procédé 1 est reliée par une canalisation 2 munie de vannes 3a, 3b, 3c à un corps de pompe 4 entraîné par un moteur 5. Le corps de pompe 4 est mis en relation avec une canalisation d'évacuation 6 par un silencieux 7. La canalisation peut être équipée d'un piège 8 pour capter les sous-produits solides de la réaction. Lorsque les sous-produits gazeux du procédé mis en oeuvre ne peuvent être rejetés dans l'évacuation générale 9, l'échappement des gaz s'effectue par l'intermédiaire d'une installation de traitement 10 grâce aux vannes 11 a et 11 b. Des gaz du procédé peuvent se transformer en sous-produits solides et s'accumuler dans la chambre de procédé 1, dans la canalisation 2 reliant la chambre 1 au corps de pompe 4, dans le corps de pompe 4, dans le silencieux 7, dans la canalisation 6 qui conduit à l'installation de traitement des gaz 10, dans le piège 8 et dans les vannes 11a, 11 b. Il est également fréquent que les sous-produits formés en amont du groupe de pompage soient pompés ou transférés par gravité dans le corps de pompe 4, et ainsi contribuent au phénomène de pollution du corps de pompe 4, du silencieux 7, de la canalisation 6 d'évacuation des gaz pompés, du piège 8 et des vannes 11a et 11 b.

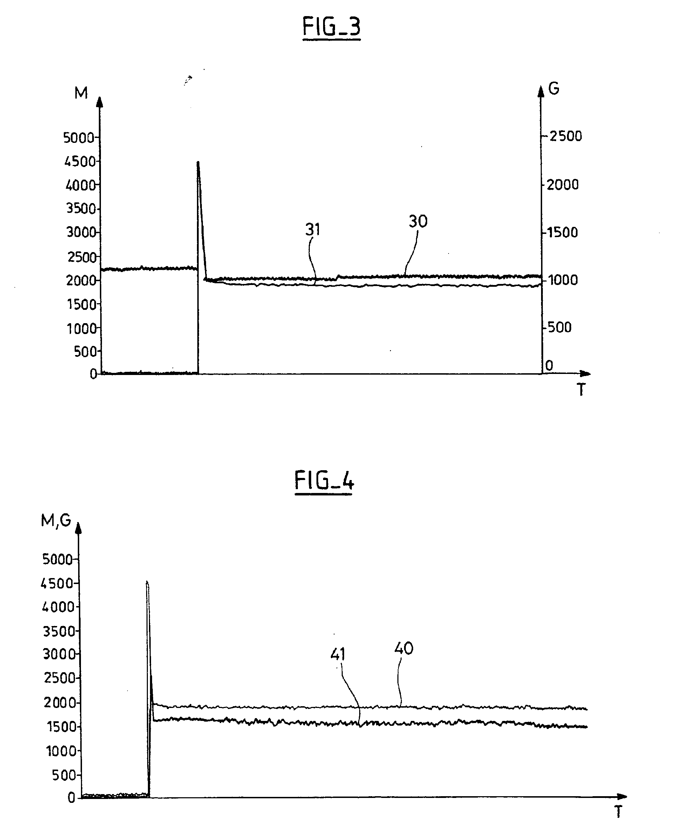

La variation de la valeur d'un paramètre fonctionnel du groupe de pompage, liée à un fonctionnement normal, peut être par exemple :
- répétitive et reproductible dans le temps, par exemple la figure 2 illustre la variation de la pression des gaz G (courbe 20) dans le système d'évacuation et de la puissance consommée par le moteur M (courbe 21) qui est due aux variations du flux gazeux parvenant au groupe de pompage lorsque des opérations de production sont en cours, ou
- ponctuelle, par exemple la figure 3 illustre l'augmentation brutale simultanée de la pression des gaz G (courbe 30) et de la puissance consommée par le moteur M (courbe 31) qui est due au pompage d'un volume de gaz à pression atmosphérique, ou encore
- continue dans le temps, par exemple la figure 4 illustre la diminution progressive de la puissance consommée par le moteur M' (courbe 41) de la pompe primaire du groupe après le démarrage, qui est due au réchauffement du groupe de pompage et à l'évacuation progressive des résidus solides accumulés dans le corps de pompe lors de la phase d'arrêt. La courbe 40 représente la puissance consommée par le moteur M de la pompe secondaire du groupe.

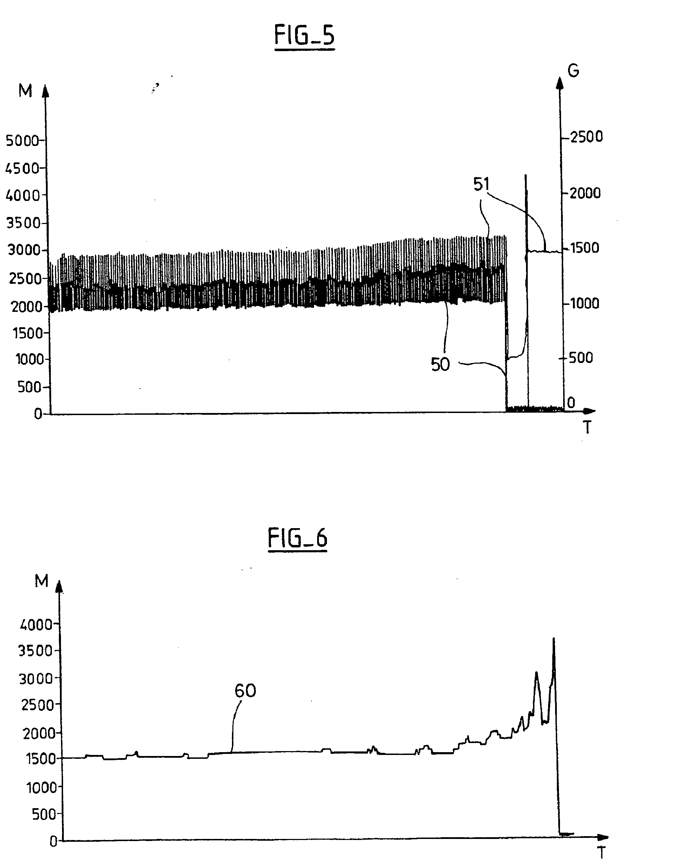

La variation de la valeur d'un paramètre liée à un fonctionnement anormal peut être par exemple :
- continue dans le temps, par exemple la figure 5 illustre l'augmentation progressive de la puissance consommée par le moteur M (courbe 50) et de la pression des gaz G (courbe 51) dans le système d'évacuation, qui révèle un colmatage de la canalisation de refoulement des gaz pompés, ou bien
- aléatoire, par exemple la courbe 60 de la figure 6 illustre des pics de puissance consommée par le moteur M successifs qui sont le signe d'un blocage imminent des pièces dynamiques.

L'invention permet notamment de détecter les phénomènes suivants avant qu'ils n'induisent une défaillance irréversible du groupe de pompage, notamment un colmatage du silencieux, du piège, de la canalisation ou des vannes du système d'évacuation des gaz, et dans certaines conditions un colmatage interne du groupe de pompage par des sous-produits solides issus de la transformation des gaz pompés.

Le colmatage est identifié par le suivi de l'évolution dans le temps de la puissance consommée par le moteur M et de la pression des gaz G. Un algorithme mathématique a été déterminé pour mesurer cette évolution et calculer le temps restant avant d'atteindre des seuils analogiques critiques prédéfinis.

Bien entendu, la présente invention n'est pas limitée aux modes de réalisation décrits, mais elle est susceptible de nombreuses variantes accessibles à l'homme de l'art sans que l'on s'écarte de l'esprit de l'invention. En particulier, on pourra sans sortir du cadre de l'invention choisir de surveiller en outre d'autres paramètres qu'ils soient internes ou externes à la ligne de vide pour une meilleure connaissance de son état fonctionnel.

## Revendications

1. Ligne de vide pour le pompage des gaz dans une chambre de procédé, comportant au moins
- un groupe de pompage comprenant un corps de pompe et un moteur,
- un système d'évacuation des gaz pompés hors du corps de pompe,
- un premier moyen de mesure d'un paramètre fonctionnel relatif au moteur, et
- un moyen de prévision de la durée d'utilisation de la ligne de vide,
**caractérisée en ce que** le moyen de prévision calcule la durée d'utilisation de la ligne de vide avant défaillance du groupe de pompage; à partir de signaux internes à la ligne de vide, lesdits signaux étant la mesure d'un paramètre fonctionnel relatif au moteur fournie par le premier moyen et la mesure d'un paramètre fonctionnel relatif au système d'évacuation fourni par un deuxième moyen de mesure d'un paramètre fonctionnel relatif au système d'évacuation des gaz pompés hors du corps de pompe.

2. Ligne de vide selon la revendication 1, dans laquelle le premier moyen de mesure d'un paramètre fonctionnel relatif au moteur est un moyen de mesure d'au moins une caractéristique choisie parmi la puissance consommée par le moteur, le courant consommé par le moteur, le couple de rotation du moteur et les vibrations du moteur.

3. Ligne de vide selon la revendications 2, dans laquelle le premier moyen de mesure d'un paramètre fonctionnel relatif au moteur est un moyen de mesure de la puissance consommée par le moteur.

4. Ligne de vide selon l'une des revendications précédentes, comprenant un premier moyen de mesure de la puissance consommée par le moteur, un deuxième moyen de mesure de la pression des gaz dans le système d'évacuation et un moyen de prévision de la durée d'utilisation de la ligne de vide à partir de la mesure de la puissance consommée par le moteur et de la mesure de la pression des gaz dans le système d'évacuation.

5. Ligne de vide selon l'une des revendications précédentes, comprenant en outre un troisième moyen de mesure d'un paramètre fonctionnel relatif au corps de pompe.

6. Ligne de vide selon la revendication 5, dans laquelle le moyen de mesure d'un paramètre fonctionnel relatif au corps de pompe est un moyen de mesure d'au moins une caractéristique choisie parmi la température du corps de pompe, les vibrations du corps de pompe, le débit de purge d'azote et la position dès vannes de régulation thermique.

7. Ligne de vide selon l'une des revendication 5 et 6, dans laquelle le moyen de prévision calcule la durée d'utilisation de la ligne de vide avant défaillance du groupe de pompage, à partir de la mesure d'un paramètre fonctionnel relatif au moteur fournie par le premier moyen, de la mesure d'un paramètre fonctionnel relatif au système d'évacuation fourni par le deuxième moyen et de la mesure d'un paramètre fonctionnel relatif au corps de pompe fournie par le troisième moyen.

8. Procédé de surveillance d'une ligne de vide selon l'une des revendications précédentes, comprenant les étapes suivantes :
- on mesure un paramètre fonctionnel relatif au moteur,
- on mesure un paramètre fonctionnel relatif au système d'évacuation des gaz,
- on effectue la corrélation de l'évolution temporelle du paramètre fonctionnel mesuré relatif au moteur et du paramètre fonctionnel mesure relatif au système d'évacuation,
- on en déduit la durée d'utilisation de la ligne de vide prévisible avant défaillance.

9. Procédé selon la revendication 8, dans lequel la durée d'utilisation prévisible est obtenue par un traitement statistique basé sur l'évolution temporelle de l'amplitude des paramètres mesurés.

10. Procédé selon l'une des revendications 8 et 9 dans lequel le paramètre fonctionnel mesuré relatif au moteur est constitué d'au moins une caractéristique choisie parmi la puissance consommée par le moteur, le courant consommé par le moteur, le couple de rotation du moteur et les vibrations du moteur.

11. Procédé selon, l'une des revendications 8 à 10, dans lequel le paramètre fonctionnel mesuré relatif au système d'évacuation des gaz est la pression des gaz dans le système d'évacuation.

12. Procédé selon l'une des revendications 8 à 11, dans lequel le paramètre fonctionnel mesuré relatif au moteur est la puissance consommée par le moteur, le paramètre fonctionnel mesuré relatif ou système d'évacuation des gaz est la pression des gaz dans le système d'évacuation, et la durée d'utilisation de la ligne de vide est calculée à partir l'évolution temporelle corrélée de la puissance consommée par le moteur et de la pression des gaz dans le système d'évacuation.

13. Procédé selon l'une des revendications 8 à 12, dans lequel on mesure en outre un paramètre fonctionnel relatif au corps de pompe.

14. Procédé Selon la revendication 13, dans lequel le paramètre fonctionnel relatif au corps de pompe est constitué d'au moins une caractéristique choisi parmi la température du corps de pompe, les vibrations du corps de pompe, le débit de purge d'azote, et la position des vannes de régulation thermique.

## Claims

1. Vacuum line for the pumping of gas in a process chamber, comprising at least
- a pumping group comprising a pump body and a motor,
- a discharge system for exhausting the pumped gas out of the pump body,
- a first means of measuring a functional parameter relative to the motor, and
- a means for forecasting the vacuum line operating time,
**characterised in that** the forecasting means calculates the vacuum line operating time before failure of the pumping group from the internal signal of the vacuum line, said signals being the measurement of a functional parameter relative to the motor supplied by the first means and the measurement of a functional parameter relative to the discharge system supplied by a second means of measuring a functional parameter relative to the discharge system for exhausting the pumped gas out of the pump body.

2. Vacuum line according to Claim 1, in which the first means of measuring a functional parameter relative to the motor is a means of measuring at least one feature chosen from between the motor power consumption, the motor current consumption, the motor rotational torque and the motor vibrations.

3. Vacuum line according to Claim 2, in which the first means of measuring a functional parameter relative to the motor is a means of measuring the motor power consumption.

4. Vacuum line according to any one of the preceding claims, comprising a first means of measuring the motor power consumption, a second means of measuring the gas pressure in the discharge system and a means of forecasting the vacuum line operating time from the motor power consumption measurement and the discharge system gas pressure measurement.

5. Vacuum line according to any one of the preceding claims, comprising furthermore a third means of measuring a functional parameter relative to the pump body.

6. Vacuum line according to Claim 5, in which the means of measuring a functional parameter relative to the pump body is a means of measuring at least one feature chosen from between the pump body temperature, the pump body vibrations, the nitrogen bleed flow and the position of the thermal control valves.

7. Vacuum line according to any one of claims 5 or 6, in which the forecasting means calculate the vacuum line operating time after failure of the pumping group, from the measurement of a functional parameter relative to the motor supplied by the first means, from the measurement of a functional parameter relative to the discharge system supplied by the second means, and from the measurement of a functional parameter relative to the pump body supplied by the third means,

8. Vacuum line monitoring method according to any one of the preceding claim, comprising the following steps:
- one measures a functional parameter relative to the motor,
- one measures a functional parameter relative to the gas discharge system,
- one carries out the temporal revolution correlation of the measured functional parameter relative to the motor and of the measured functional parameter relative to the discharge system,
one infers the predictable vacuum line operating time before failure

9. Method according to Claim 8, in which the predictable operating time is obtained by a statistical treatment based on the temporal evolution of the measured parameter amplitude.

10. Method according to any one of Claims 8 and 9 in which the measured functional parameter relative to the motor is made up of at least one feature chosen from between the motor power consumption, the motor current consumption, the motor rotational torque and the motor vibrations.

11. Method according to any one of Claims 8 through 10, in which the measured functional parameter relative to the gas discharge system is the gas pressure in the discharge system

12. Method according to any on of Claims 8 through 11, in the measured functional parameter relative to the motor is the motor power consumption, the measured functional parameter relative to the gas discharge system is the discharge system gas pressure, and the vacuum line operating time is calculated from the correlated temporal evolution of the motor power consumption and of the discharge system gas pressure

13. Method according to any one of Claims 8 through 12, in which one additionally measures a functional parameter relative to the pump body.

14. Method according to Claim 13 in which the functional parameter relative to the pump body is made up of at least one feature chosen from between the pump body temperature, the pump body vibrations, the nitrogen bleed flow, and the position of the thermal control valves

## Patentansprüche

1. Vakuum-Pumpeinrichtung zum Pumpen der Gase in einer Prozesskammer, welche mindestens umfasst:
- Einen Pumpensatz mit einem Pumpengehäuse und einem Motor,
- eine Gasabführvorrichtung, um die gepumpten Gase aus dem Pumpengehäuse abzulassen,
- ein erstes Messmittel zum Messen eines Funktionsparameters des Motors, und
- ein Vorhersagemittel zum Vorhersagen der Benutzungsdauer der Vakuum-Pumpeinrichtung,
**dadurch gekennzeichnet, dass** das das Vorhersagemittel die Benutzungsdauer der Vakuum-Pumpeinrichtung vor Ausfall des Pumpensatzes kalkuliert, anhand internen Signalen der Vakuum-Pumpeinrichtung, wobei die besagten Signale die von einem ersten Mittel gelieferte Messung eines Funktionsparameters des Motors und die von einem zweiten Messmittel gelieferte Messung eines Funktionsparameters der Gasabführvorrichtung der gepumpten Gase, welche aus dem Pumpengehäuse abgelassen werden, sind.

2. Vakuum-Pumpeinrichtung nach Anspruch 1, wobei das erste Messmittel eines Funktionsparameters des Motors ein Messmittel mit mindestens einer Eigenschaft, gewählt unter der vom Motor verbrauchten Leistung, dem vom Motor verbrauchten Strom, dem Drehmoment des Motors und den Schwingungen des Motors.

3. Vakuum-Pumpeinrichtung nach Anspruch 2, wobei das erste Messmittel eines Funktionsparameters des Motors ein Messmittel der vom Motor verbrauchten Leistung ist.

4. Vakuum-Pumpeinrichtung nach einem beliebigen der vorstehenden Ansprüche, umfassend ein erstes Mittel zum Messen der von dem Motor verbrauchten Leistung, ein zweites Mittel zum Messen des Drucks der Gase in der Gasabführvorrichtung und ein Mittel zum Vorhersagen der Benutzungsdauer der Vakuum-Pumpeinrichtung anhand der Messung der vom Motor verbrauchten Leistung und von der Messung des Drucks der Gase in der Gasabführvorrichtung.

5. Vakuum-Pumpeinrichtung nach einem beliebigen der vorstehenden Ansprüche, weiterhin umfassend ein drittes Mittel zum Messen eines Funktionsparameters des Pumpengehäuses.

6. Vakuum-Pumpeinrichtung nach Anspruch 5, wobei das Mittel zum Messen eines Funktionsparameters des Pumpengehäuses ein Mittel zum Messen von mindestens einer Eigenschaft, gewählt unter der Temperatur des Pumpengehäuses, den Schwingungen des Pumpengehäuses, der Stickstoff-Ablassgeschwindigkeit und der Stellung der thermischen Regelventile, ist.

7. Vakuum-Pumpeinrichtung nach einem beliebigen der Ansprüche 5 und 6, wobei das Vorhersagemittel die Benutzungsdauer der Vakuum-Pumpeinrichtung von Ausfall des Pumpensatzes anhand der von dem ersten Mittel gelieferten Messung eines Funktionsparameters des Motors, der von dem zweiten Mittel gelieferten Messung eines Funktionsparameters der Gasabführvorrichtung und der von dem dritten Mittel gelieferten Messung eines Funktionsparameters des Pumpengehäuses kalkuliert.

8. Überwachungsverfahren einer \/akuum-Pumpeinrichtung nach einem der vorstehenden Ansprüche, welches die folgenden Schritte umfasst:
- Messung eines Funktionsparameters des Motors,
- Messung eines Funktionsparameters der Gasabführvorrichtung,
- Herstellen der Korrelation der zeitlichen Entwicklung des gemessenen Funktionsparameters des Motors und des gemessenen Funktionsparameters der Gasabführvorrichtung,
- Ableiten der absehbaren Benutzungsdauer der Vakuum-Pumpeinrichtung vor deren Ausfall.

9. Verfahren nach Anspruch 8, wobei die absehbare Benutzungsdauer anhand einer auf der zeitlichen Entwicklung der Amplitude der gemessenen Parameter basierenden statistischen Verarbeitung erhalten wird.

10. Verfahren nach einem beliebigen der Ansprüche 8 und 9, wobei der gemessene Funktionsparameter des Motors aus mindestens einer der unter der vom Motor verbrauchten Leistung, dem vom motor verbrauchten Strom, dem Drehmoment des Motors und den Schwingungen des Motors gewählten Eigenschaft besteht.

11. Verfahren nach einem beliebigen der Ansprüche 8 bis 10, wobei der gemessene Funktionsparameter der Gasabführvorrichtung der Druck der Gase in der Abführvorrichtung ist.

12. Verfahren nach einem beliebigen der Ansprüche 8 bis 11, wobei der gemessene Funktionsparameter des Motors die vom Motors verbrauchte Leistung ist, der gemessene Funktionsparameter der Gasabführvorrichtung der Druck der Gase in der Abführvorrichtung ist, und die Benutzungsdauer der Vakuum-Pumpeinrichtung anhand der in Korrelation gebrachten zeitlichen Entwicklung der vom Motor verbrauchten Leistung und des Drucks der Gase in der Abführvorrichtung kalkuliert wird.

13. Verfahren nach einem beliebigen der Anspruche 8 bis 12, wobei weiterhin ein Funktionsparameter des Pumpengehäuses gemessen wird.

14. Verfahren nach Anspruch 13, wobei der Funktionsparameter des Pumpengehäuse aus mindestens einer Eigenschaft, gewählt unter der Temperatur des Pumpengehäuses, den Schwingungen des Pumpengehäuses, der Stickstoff-Ablassgeschwindigkeit und der Stellung der thermischen Regelventile, besteht.
